Europäisches Patentamt

(19) European Patent Office

Office européen des brevets

(11) EP 0 800 203 A2

## (12) EUROPEAN PATENT APPLICATION

(43) Date of publication:
08.10.1997 Bulletin 1997/41

(51) Int. Cl.⁶: **H01L 21/00**

(21) Application number: 97105221.2

(22) Date of filing: 27.03.1997

(84) Designated Contracting States:
DE FR GB IT

(30) Priority: 04.04.1996 US 627532

(71) Applicant: **APPLIED MATERIALS, INC.**
Santa Clara California 95051 (US)

(72) Inventor: **Tepman, Avi**
Cupertino, California 95014 (US)

(74) Representative: **Kahler, Kurt, Dipl.-Ing.**
**Patentanwälte**
**Kahler, Käck, Fiener et col.,**
**Vorderer Anger 268**
**86899 Landsberg/Lech (DE)**

### (54) Multiple load lock system

(57) A semiconductor processing system (100) having at least three load lock chambers (A, B, C) in which contamination from particles generated by loading and unloading of semiconductor workpieces can be substantially reduced.

Fig. 6

## Description

## BACKGROUND OF THE INVENTION

The present invention relates to semiconductor processing systems, and more particularly, to semiconductor processing systems having removable cassettes for holding processed and unprocessed work pieces.

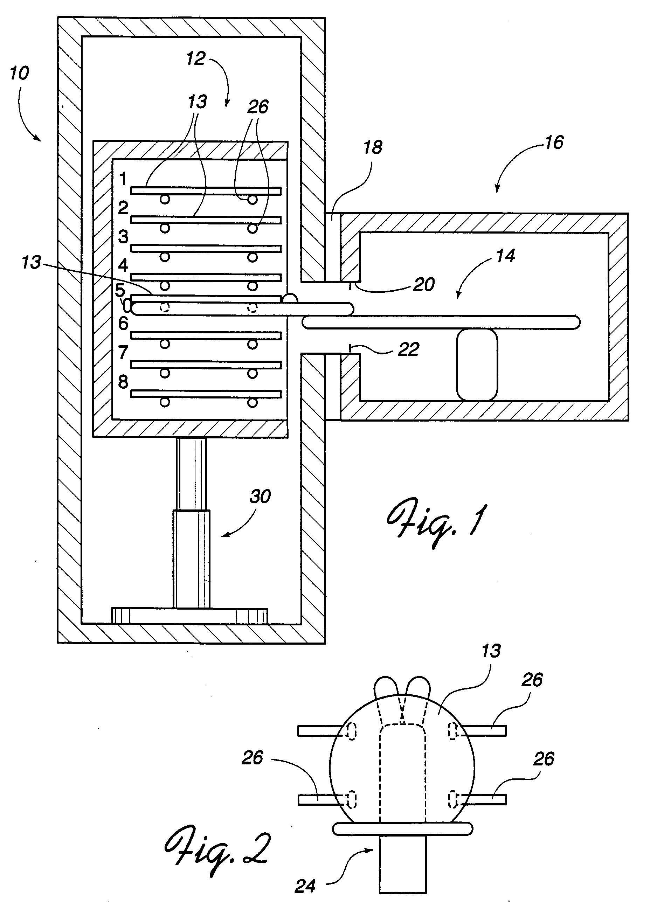

In order to decrease contamination and to enhance throughput, semiconductor processing systems often utilize one or more robots to transfer semiconductor wafers, substrates and other work pieces between a number of different vacuum chambers which perform a variety of tasks. An article entitled "Dry Etching Systems: Gearing Up for Larger Wafers", in the October, 1985 issue of Semiconductor International magazine, pages 48-60, describes a four-chamber dry etching system in which a robot in a pentagonal-shaped housing serves four plasma etching chambers and a load lock chamber mounted on the robot housing. Fig. 1 of the present application illustrates a typical load lock chamber 10 having a cassette 12 for holding unprocessed wafers 13 to be unloaded by a robot 14 and transferred to various processing chambers (not shown).

The load lock chamber 10 is a pressure-tight enclosure which is coupled to a robot chamber 16 by interlocking seals 18 which permit the load lock chamber to be removed and reattached to the robot chamber as needed. The cassette 12 is loaded into the load lock chamber 10 through a rear door (not shown) which is closed in a pressure-tight seal. The wafers are transferred between the robot chamber 16 and the load lock chamber 10 through a passageway 20 which may be closed by a slit valve 22.

Although only eight wafers are illustrated for purposes of clarity, a typical cassette 12 may be initially loaded with as many as 25 or more unprocessed wafers 13 or other work pieces before the cassette is loaded into the load lock chamber 10. After the load lock access door is closed and sealed, the load lock chamber is then pumped by a pump system (not shown) down to the vacuum level of the robot chamber 16 before the slit valve 22 is opened. The robot 14 which is mounted in the robot chamber 16 then unloads the wafers from the cassette one at a time, transferring each wafer in turn to the first processing chamber. As best seen in Fig. 2, the robot 14 includes a robot hand or blade 24 which is moved underneath the wafer 13 to be unloaded. The robot 14 then "lifts" the wafer 13 from the wafer supports 26 supporting the wafers 13 in the cassette 12. By "lifting," it is meant that either the robot blade 24 is elevated or the cassette 12 is lowered by a suitable lifting mechanism such that the wafer 13 is lifted off the cassette wafer supports 26. The wafer may then be withdrawn from the cassette 12 through the passageway 20 and transferred to the first processing chamber.

Once a wafer has completed its processing in the first processing chamber, that wafer is transferred to the next processing chamber and the robot 14 unloads another wafer from the cassette 12 and transfers it to the first processing chamber. When a wafer has completed all the processing steps of the wafer processing system, the robot 14 typically returns the processed wafer back to the cassette 12 from which it came. Once all the wafers have been processed and returned to the cassette 12, the cassette in the load lock chamber is removed and another full cassette of unprocessed wafers is reloaded.

One problem associated with systems having single load lock chamber and cassette is that the robot will run out of unprocessed wafers to unload before all the wafers are processed and returned to the cassette. Processing chambers will become idle as the last wafer works its way through the system. The time necessary for each wafer to pass through each of the processing chambers and to return to the cassette depends upon the number of processing chambers in the system and the time required for each processing step. Some systems have as many as 10 processing chambers in which each processing step can take 2 minutes or more. Thus, in some systems it can take 20 minutes or longer for the last wafer to return to the cassette, during which time the processing of additional wafers is halted.

Furthermore, once the cassette has been filled with the processed wafers, it is necessary to vent the load lock chamber, remove the old cassette and insert a cassette of unprocessed wafers into the load lock and then pump down the load lock chamber to the vacuum level of the robot chamber. Although the increased vacuum isolation provided by such systems can improve product quality, it has been difficult to achieve commercially acceptable throughput for high vacuum processes, such as, for example, physical vapor processes such as sputtering. The time required to pump down the load lock chambers to the base level, following loading of a cassette of wafers into the load lock chamber, can be excessive.

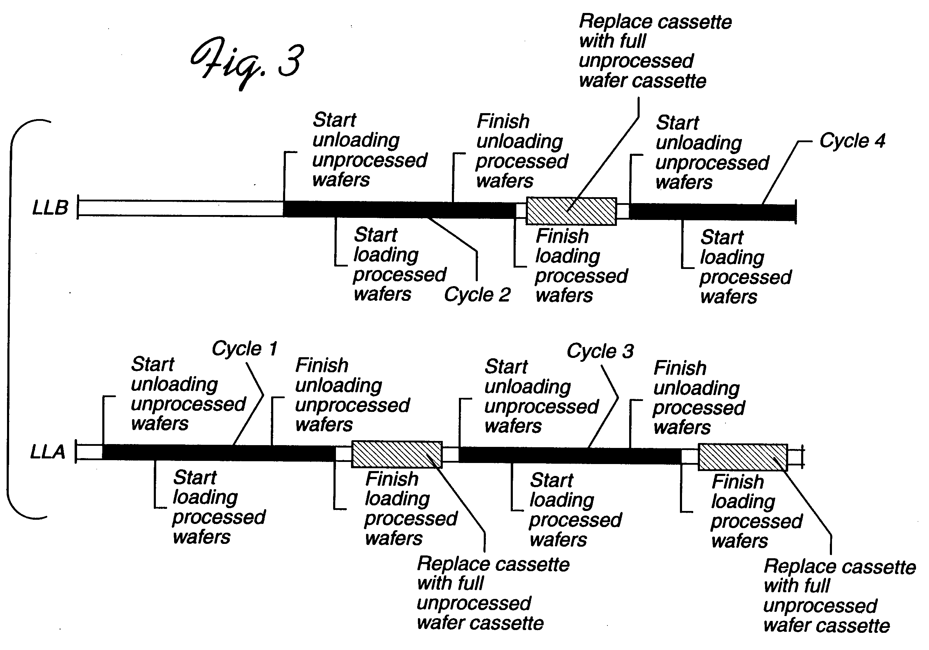

In order to increase throughput, it has been proposed to utilize two load lock chambers as described in U.S. Pat. No. 5,186,718 which is incorporated in its entirety by reference. In such a two load lock system, both load lock chambers are loaded with full cassettes of unprocessed wafers. Fig. 3 of the present application illustrates in time line form several processing cycles for such a two load lock system. As shown in Fig. 3, the robot starts unloading unprocessed wafers from the first load lock chamber A. Following a certain delay, the first wafer will have completed processing by the system. At that time, it is believed that the robot typically loads the first processed wafer back into the cassette of load lock chamber A, the same cassette from which it was unloaded. This process continues until the robot completes unloading the unprocessed wafers from the cassette of load lock chamber A. However, because the system has two load lock chambers, the processing chambers are not idled as the last wafer from load lock chamber A passes through the system. Instead, once the supply of unprocessed wafers from load lock chamber A is exhausted, the robot begins to unload unprocessed wafers from load lock chamber B to start another unload-load cycle (cycle 2) as shown in Fig. 3. As the processing of individual wafers is completed, the robot continues to return processed wafers to the cassette of load lock chamber A until the load lock chamber A cassette is filled with processed wafers (completing unload-load cycle 1). At that time, the next processed wafer (the first wafer unloaded from load lock chamber B) will be returned to the cassette of load lock B from which it was unloaded.

As the robot unloads unprocessed wafers from the cassette of load lock chamber B and returns processed wafers to the cassette of load lock chamber B, the slit valve to load lock chamber A may be closed to permit the load lock chamber A to be vented and the cassette removed and replaced with a cassette of unprocessed wafers. Once load lock chamber A has been pumped back down to the base vacuum level and the robot unloads the last unprocessed wafer from load lock chamber B, the robot can resume unloading unprocessed wafers from the cassette of load lock chamber A, initiating a third unload-load cycle (cycle 3). Thus, if the load lock chamber A with the new cassette of unprocessed wafers can be pumped down before the robot finishes unloading the cassette of load lock chamber B, processing of wafers can be continued uninterrupted.

When the robot has finished loading processed wafers into the cassette of load lock chamber B ending unload-load cycle 2, the cassette in load lock chamber B can be removed and replaced with a full cassette of unprocessed wafers. In the meantime the robot continues to unload unprocessed wafers from and load processed wafers into the cassette of load lock chamber A. In this manner, wafer processing can be maintained more continuously, significantly increasing throughput over the single load lock systems.

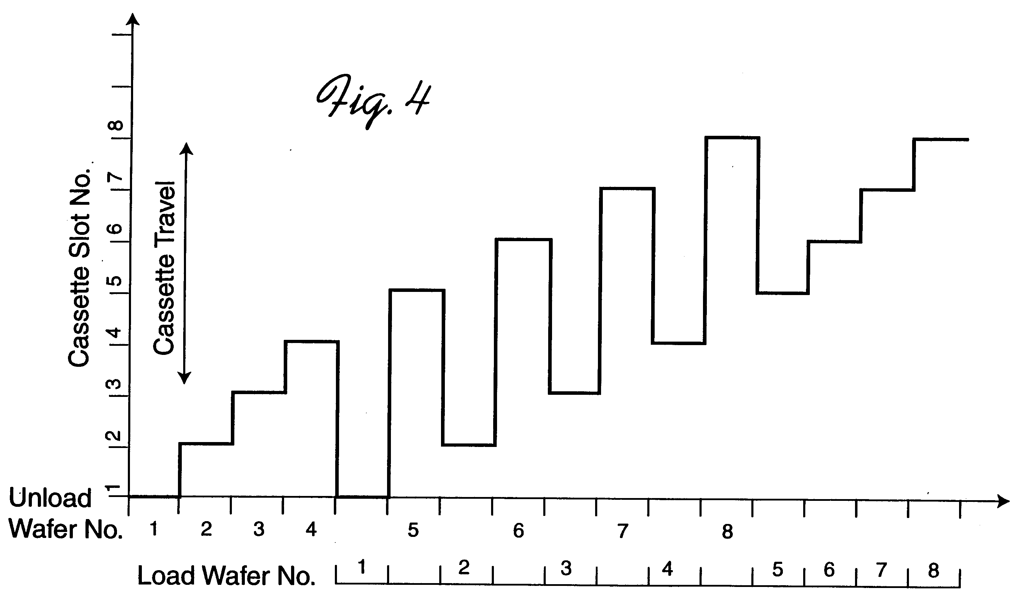

Although such systems significantly improve throughput, two load lock systems, like one load lock systems, often encounter contamination problems caused by particles generated by the frequent movements of the cassettes as the wafers are unloaded and loaded, and the movement of the substrates into and out of the cassette. A graph depicting the movements of a cassette during a typical unload-load cycle of a one load lock or two load lock system is shown in Fig. 4. In the example of Fig. 4, it is assumed that the unprocessed wafers are unloaded from the top of the cassette starting at wafer slot No. 1 (Fig. 1), continuing downward to the bottom of the cassette at wafer slot No. 8. Although cassettes typically have more than the eight slots illustrated, the drawing has been simplified for clarity. Furthermore, in this example, the wafer slots are accessed by the robot by raising and lowering the cassette rather than raising and lowering the robot arm. Hence, when the robot arm is aligned with the top wafer slot (slot No. 1) the cassette 12 of Fig. 1 is lowered to its lowest position. Thus, to unload the first wafer from slot No. 1, the cassette is initially at its lowest position as indicated in Fig. 4. To unload the next wafer (wafer No. 2) from wafer slot No. 2, the cassette 12 is indexed upwardly so that the next slot (wafer slot No. 2) is aligned with the robot blade 24.

The first wafer is deposited into the first processing station by the transfer robot. After processing at the first station is completed, the first wafer is moved to the next processing station and the second wafer is unloaded from the cassette and moved to the first processing station. As each wafer is unloaded from the cassette, the space between the top of the cassette and the next wafer to be removed therefrom grows larger. In the illustrated embodiment, the processing system of this example has four processing stations. Hence, when all four processing stations are filled, there will be four empty slots at the top of the cassette. After the fourth wafer is unloaded from wafer slot No. 4 and transferred to the first processing chamber, it is assumed that the first wafer, wafer No. 1, has completed all processing by the system and is ready to be returned to the cassette 12. However, the robot blade is aligned with wafer slot No. 4 at that time since the last wafer was unloaded from slot No. 4. Consequently, it is necessary to lower the cassette a distance equal to three slot heights until the robot blade is realigned with wafer slot No. 1 as illustrated in Fig. 4. Once aligned, the robot can return processed wafer No. 1 back to wafer slot No. 1.

However, the next unprocessed wafer to be unloaded is back at wafer slot No. 5. There are three empty wafer slots between the processed wafer in slot No. 1 and the next unprocessed wafer in slot No. 5. Thus, the cassette needs to be raised a distance equal to four slot heights until the robot blade is aligned with wafer slot No. 5. After unprocessed wafer No. 5 is unloaded, it will be necessary for the robot to return three wafer slot spaces back to wafer slot No. 2 to load processed wafer No. 2. As a consequence, as wafers are alternatively unloaded and loaded, an empty space of four empty wafer slots incrementally moves down the cassette. (If there are more wafer rest positions in the system, i.e., locations where a wafer is processed, held or supported in the chamber, the number of empty slots will be greater.) It is apparent from Fig. 4 that the cassette is moved up and down a relatively large distance across this moving empty space each time a wafer is to be loaded or unloaded until the last unprocessed wafer (wafer No. 8) is unloaded.

Movement of the cassette can cause significant vibration of both the cassette and the wafers in the cassette, leading to the generation of particles being jarred from the wafers and landing on any wafers located below within the cassette. In the example of Fig. 4, the cassette was moved down three wafer slot heights each time a processed wafer needed to be loaded, and was moved up four wafer slots each time an unprocessed wafer was to be unloaded, because the system had four processing stations. In many applications, wafer processing systems have many more wafer processing stations. Some wafer processing systems have over fourteen stations including processing chambers, degas chambers and stations such as wafer orienter stations. In such a system, the cassette can be raised and then lowered a distance equal to thirteen or fourteen wafer slot heights each time a processed wafer is to be loaded followed by the unloading of an unprocessed wafer to span the gap between the last open slot for a processed wafer and the closest unprocessed wafer.

Moreover, these movements are multiplied the more wafers a cassette has. For example, if a cassette has 25 wafers rather than the 8 wafers illustrated, the cassette can be caused to oscillate up and down over 20 times by the time the cassette has been fully reloaded with processed wafers.

In addition to any reduced throughput caused by the raising and lowering of the cassette, the movement of the cassettes can cause vibrations which can cause the generation of contaminant particles. In order to reduce the generation of particulates, the movement of the cassette between slot alignments can be slowed to provide as smooth a movement as possible. However, this can substantially slow down throughput when the robot is caused to wait for the cassette to align the proper wafer slot with the robot blade. As the robot waits for the cassette to move the next unprocessed wafer into position to be unloaded, or as the robot waits for the cassette to move the wafer slot into position to load the next processed wafer, processing chambers can become idled thereby losing valuable processing time and reducing throughput.

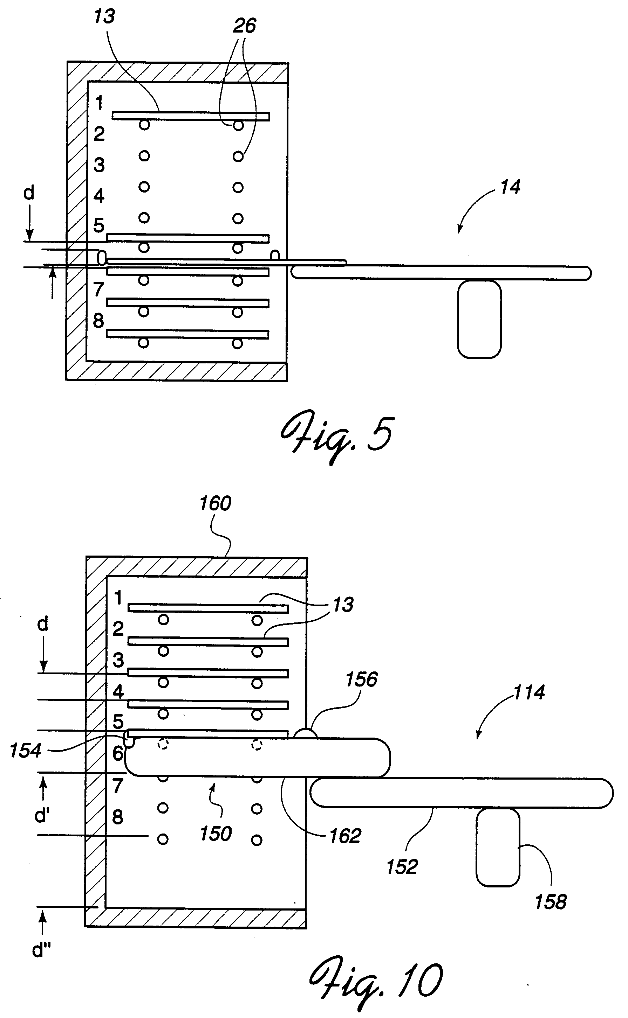

Still further, as the robot blade moves into position to pick up a wafer to unload that wafer from the cassette, it is often necessary for the robot blade to pass in between two adjacent wafers as shown in Fig. 5. In order to prevent damage to the wafers or to prevent the generation of contaminating particles, it is important that the robot blade not strike either of the wafers as the robot blade moves between them to pick up the upper wafer. In many cassettes, the wafers are supported at the wafer outer edges such that the wafers and especially the larger wafers can bow in the middle. This reduces the clearance between adjacent wafers and between wafers and cassette wafer supports and increases the chances of the robot blade or a wafer support scraping a bowed wafer as the wafer is loaded or unloaded. As a result, the robot blade and cassette slots should be precisely positioned for robot blade alignment. The need for precise positioning of the robot blade relative to the cassette slots for each loading and unloading procedure can further slow down the processing cycle, leading to further degradation of throughput.

Of course, such a robot blade must also be substantially thinner than the minimum spacing between the wafers in order to be able to fit between adjacent wafers without striking either wafer. Because the wafers are stacked relatively closely in the cassette, often as close as 1/4 inch or closer, severe restraints are placed upon the maximum allowable thickness of the robot blade. Additionally, as wafer diameters (or surface area) increase, but wafer spacing within the cassette does not, the length of the blade must be increased without a corresponding increase in blade thickness, further weakening the blade strength and rigidity. As a result, robot blades are often not as structurally strong as desired, and material choices for the blade naturally are limited. It is important to prevent the robot blade from bending from the weight of the wafer or warping from being exposed to relatively widely differing extremes of temperatures ranging from 25° C to 800° C. If the robot blade warps or bends sufficiently out of alignment, the blade can strike a wafer during the loading or unloading of a wafer.

## SUMMARY OF THE INVENTION

It is an object of the present invention to provide a work piece loading and unloading System obviating for practical purposes, the above limitations, particularly in a manner requiring a relatively uncomplicated electro-mechanical arrangement.

This object is solved by the features described in claims 1, 2, 8, 9, 17, 18, and 19, respectively. Particular embodiments of the invention are set out in the dependent claims. In particular, these and other objects and advantages are achieved in a semiconductor processing system having at least three cassettes for holding processed and unprocessed wafers or other work pieces. In the illustrated embodiment, a robot unloads unprocessed wafers from a first cassette in a first load lock chamber. As the wafers are processed, the processed wafers are loaded into a second cassette in a second load lock chamber. As unprocessed wafers are unloaded from the first cassette and the processed wafers are loaded into the second cassette, a third cassette full of processed wafers in a third load lock chamber is removed and replaced with a full cassette of unprocessed wafers. Once all the unprocessed wafers have been unloaded from the first cassette, the robot begins to unload unprocessed wafers from the third cassette. When the second cassette has been fully loaded with processed wafers, the second load lock chamber is removed and replaced with a full cassette of unprocessed wafers. As the wafers from the third cassette are processed, those processed wafers are loaded into the first cassette. In this manner, processing can be maintained as unprocessed wafers from one cassette are processed and loaded into a different cassette while yet another cassette which is already full of processed wafers is replaced by a cassette of unprocessed wafers.

Such an arrangement has a number of advantages as discussed in greater detail below. For example, by designating one cassette full of unprocessed wafers to be the source cassette and one empty cassette to be the destination cassette, the unprocessed wafers being loaded from the source cassette can preferably be unloaded from the bottom up while the processed wafers are preferably loaded into the destination cassette from the top down. As a result, wafers can always be unloaded and loaded with no wafers in position below the wafer being loaded or unloaded. Consequently, any particles generated from the wafer being loaded or unloaded do not fall onto wafers below because there are no wafers below.

Furthermore, by designating a cassette to be used only as a source cassette during a particular unloading and loading cycle, the movements of the cassette (or alternatively the robot blade) are substantially simplified. As explained in greater detail below, the cassette need only move a distance equal to the spacing between adjacent wafers each time a new wafer is to be unloaded. Consequently, the cassette can move very slowly to decrease the generation of particles without adversely impacting throughput. In a similar manner, the destination cassette need only move a distance equal to the spacing between adjacent wafer slots each time a new wafer is to be loaded. Furthermore, the destination cassette can move simultaneously with the movement of the source cassette, further increasing the efficiency at which the proper wafer slots of the cassettes are aligned with the robot blade.

Still further, because the wafers can always be unloaded from the bottom of the cassette up and loaded from the top of the cassette down, such that there is no processed wafer in the slot immediately below the wafer being unloaded or loaded, the need to carefully insert the robot blade between two adjacent wafers can be eliminated. Consequently, the need to carefully align the robot blade with respect to a wafer slot can similarly be eliminated, potentially increasing throughput. Still further, the maximum thickness restrictions on the robot blade can be relaxed, so that the robot blade can have a thickness substantially greater than the thickness of the wafer spacing. As a result, robot blades can be made much stronger to resist warping and bending. Still further, a single robot blade design can be used regardless of the wafer spacing in the cassette.

Moreover, the wafers or substrates can each be made much thicker or stacked more closely in the cassette. The resulting reduction in wafer to wafer spacing will not substantially hinder the robot blade from unloading or loading wafers if the robot blade always unloads the source cassette from the bottom up and loads the destination cassette from the top down. In a similar fashion, the tendency of larger wafers and substrates to warp or bow and thereby reduce the clearance between stacked wafers (or substrates) will not substantially impede the robot blade.

## BRIEF DESCRIPTION OF THE DRAWINGS

Fig. 1 is a partial cross-sectional view of a prior art load lock chamber and robot chamber.

Fig. 2 is a top view of the robot blade of Fig. 1 illustrated holding a wafer.

Fig. 3 is time line indicating unload and loading cycles of a prior art two load lock system.

Fig. 4 is a chart illustrating cassette movements during an unload and loading cycle for a cassette of the two load lock system of Fig. 3.

Fig. 5 is a partial cross-sectional view of a cassette illustrating a robot blade moving into position between wafers to unload a wafer.

Fig. 6 is a schematic top view of a three load lock wafer processing system in accordance with a preferred embodiment of the present invention.

Fig. 7 is a schematic top view of a three load lock wafer processing system in accordance with another preferred embodiment of the present invention.

Fig. 8 is a chart depicting several unload and load cycles of the wafer processing systems of Figs. 6 and 7.

Fig. 9 is a chart illustrating cassette movements during an unload and load cycle for a source cassette and a destination cassette of the three load lock systems of Figs. 6 and 7.

Fig. 10 shows a robot blade in accordance with a preferred embodiment of the present invention.

Fig. 11 illustrates a minimum wafer to wafer spacing in a cassette.

## DETAILED DESCRIPTION OF THE DRAWINGS

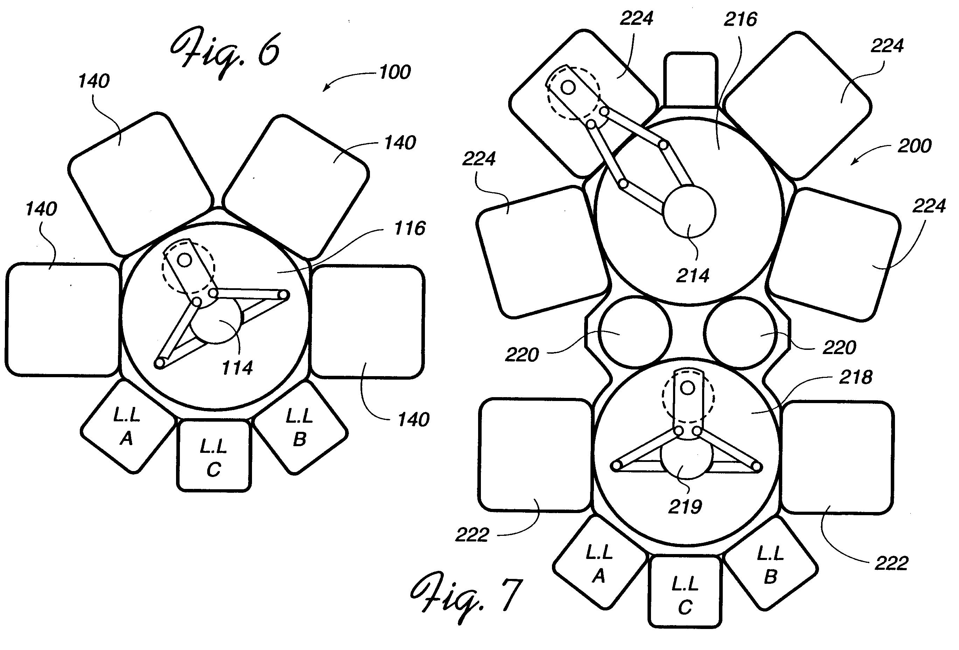

A wafer processing system in accordance with a preferred embodiment of the present invention is indicated generally at 100 in Fig. 6. The system 100 includes a robot 114 positioned in a robot chamber 116 to which are coupled three load lock chambers A, B and C. As explained in greater detail below, the three load lock chambers A, B and C can substantially reduce contamination of wafers caused by particle generation during wafer loading and unloading, without reducing throughput and can in some circumstances even increase throughput.

In the illustrated embodiment, the robot 114 is constrained to move laterally. Vertical motion of the wafers is achieved by vertically shifting the cassettes. It should be appreciated, however, that in alternative embodiments, the robot may be capable of vertical motion as well.

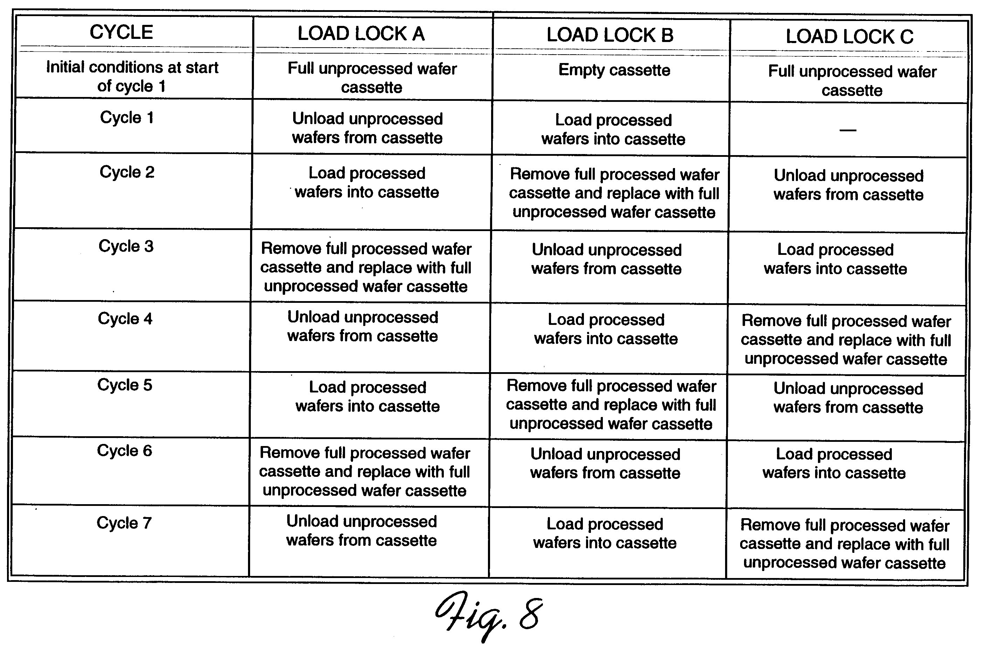

The wafer processing system 100 includes four wafer processing chambers 140 arrayed around the robot chamber 12. The processing chambers 140 may include a variety of different types of processing chambers including etch and deposition chambers as well as preprocessing and post processing chambers or stations for heating, cooling, orienting and cleaning wafers before and after processing. In the illustrated embodiment, it is preferred that two of the load lock chambers each initially be loaded with full cassettes of unprocessed wafers while the third load lock chamber have an empty cassette. Thus, for example, both load lock A and load lock C may each be loaded with a cassette full of unprocessed wafers as indicated in Fig. 8. Load lock B on the other hand is loaded with an empty cassette.

The robot 114 unloads the unprocessed wafers from one cassette, one wafer at a time, and transfers the unprocessed wafers to each of the processing chambers 140 in sequence until each wafer has completed processing. Once processing is complete, rather than returning the processed wafer to the cassette from which it originated, the robot 114 loads the processed wafers into the empty cassette. Once that cassette is filled with processed wafers, it is removed and replaced with another cassette of unprocessed wafers. Additionally, by moving the wafers as they are processed into the initially empty cassette and picking wafers to be processed sequentially from the cassette of unprocessed wafers, that cassette of unprocessed wafers will become empty as the initially empty cassette becomes full. While the cassette full of processed wafers is replaced with a new cassette of unprocessed wafers, the other cassette full of unprocessed wafers is processed and loaded into the empty cassette. This cycle of unloading and loading of wafers is repeated, with the roles of the cassettes switching, in such a manner that more continuous processing of the wafers may be maintained.

Thus, in the example of Fig. 8, in the first unloading and loading cycle (cycle 1) the unprocessed wafers are unloaded from the cassette of load lock A (the source cassette) and following processing, are loaded not back into the cassette of load lock A but are instead loaded into the empty cassette of load lock B (the destination cassette). Once the robot finishes unloading the source cassette of load lock A during cycle 1, the robot can begin a new unloading and loading cycle (cycle 2) before cycle 1 is completed by unloading unprocessed wafers from load lock C. Thus, during cycle 2, the cassette of load lock C is the new source cassette.

Once the robot finishes loading processed cassettes (which originated from the cassette of load lock A) into the destination cassette of load lock B, this completes cycle 1, the first unloading and loading cycle. The cassette of load lock A is now empty and therefore it now becomes the destination cassette for the unloading and loading cycle 2. As previously mentioned, the cassette of load lock C which is filled with unprocessed wafers is the source cassette of cycle 2.

While unprocessed wafers are unloaded from the source cassette of load lock C and the processed wafers are loaded into the destination cassette of load lock A, the cassette of load lock B which was the destination cassette during cycle 1 is now full of processed wafers and may be removed and replaced during cycle 2 with another cassette of unprocessed wafers. During the next unloading and loading cycle, cycle 3, the roles of the cassettes of the three load lock chambers switch again as shown in Fig. 8. Thus, in cycle 3, the cassette of load lock B becomes the source cassette, the cassette of load lock C becomes the destination cassette and the cassette of load lock A which was filled with processed wafers in the prior cycle 2 is removed and replaced with a cassette of unprocessed wafers in cycle 3. During each succeeding unloading and loading cycle, the roles of the three cassettes continue to switch. If the cassette full of processed wafers can be replaced and pumped down prior to the time that cassette is needed as a source cassette in the next cycle, processing of wafers can continue uninterrupted except for necessary cleaning and servicing of the chambers.

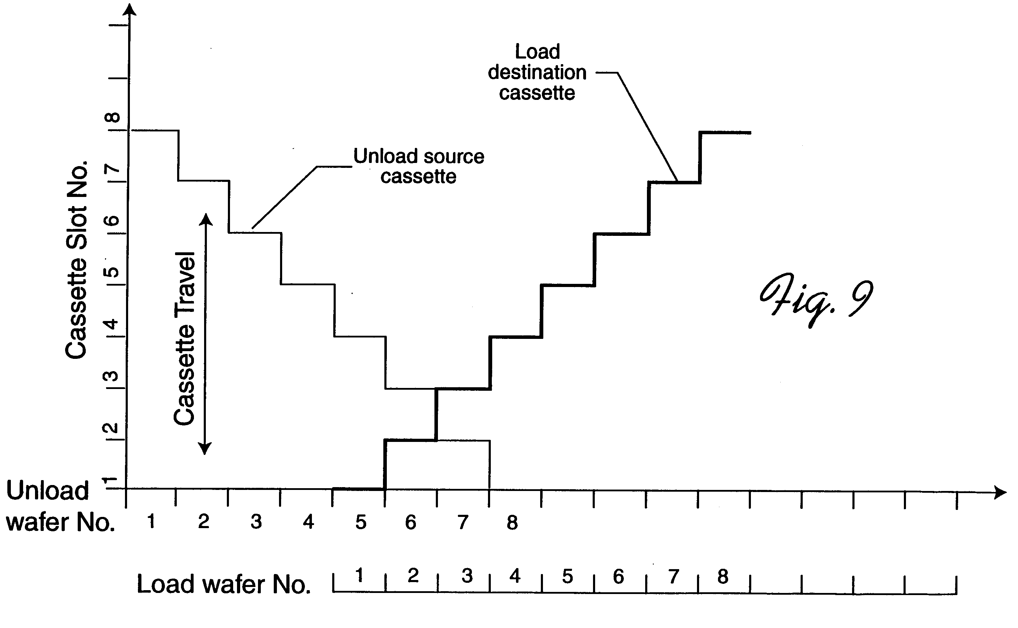

Referring now to Fig. 9, it will be shown that assigning specialized roles to each cassette during each particular loading and unloading cycle facilitates not only a high throughput but also a number of other advantages including reducing contamination due to the generation of particles during the loading and unloading processes. Fig. 9 illustrates a typical unload and load cycle of Fig. 8. As shown therein, the cycle begins by unloading a wafer from the source cassette. In the preferred embodiment, wafers are unloaded from the source cassette starting from the bottom wafer slot and working up to the top wafer slot. Because the wafers are unloaded from the bottom wafer up, there is no wafer below the wafer being unloaded. Hence, any particles generated from the wafer being unloaded by the robot will not fall onto any wafer below. Additionally, as explained in greater detail below, the thickness of the robot blade is now no longer limited by the spacing between the wafers but instead by the spacing between the bottom wafer of the cassette and the base of the cassette. This space can be increased without significantly affecting the size of the cassette or load lock. As a consequence, the thickness of the robot blade may be substantially increased, if necessary.

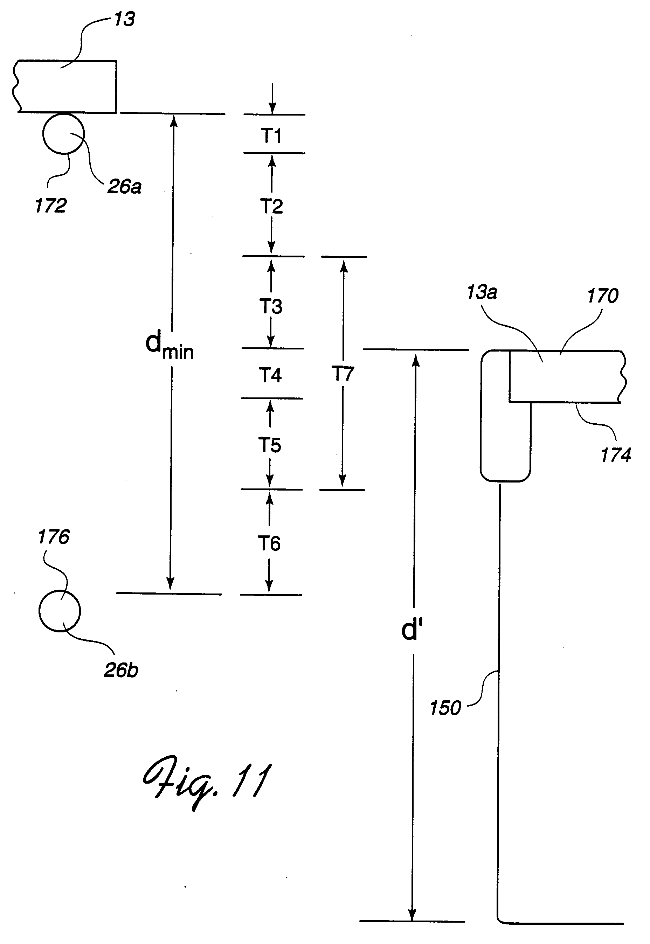

In the illustrated embodiment, the source cassette (Fig. 10) is shown as having only 8 wafer slots for purposes of clarity but it is anticipated that the cassette can have as many as 25 or more such wafer slots. As shown in Fig. 9, the bottom wafer, the first unprocessed wafer (wafer No. 1) to be unloaded in this cycle is in wafer slot No. 8. To align the robot with wafer slot No. 8, it is necessary that the source cassette be raised to the top of the associated load lock chamber. This is preferably done very slowly so as to minimize any shaking or rattling of the unprocessed wafers which could generate contaminating particles. So as not to adversely affect throughput, the source cassette can be advantageously prepositioned to align wafer slot No. 8 with the robot while the load lock chamber is being pumped down following the replacement of the cassette with a cassette filled with wafers in the prior unload and load cycle.

Once the robot unloads the first wafer from slot No. 8, the source cassette can be very slowly lowered as shown in Fig. 9 to position the wafer of the next wafer slot, i.e. wafer slot No. 7, to be in alignment with the robot to prepare for the next wafer to be unloaded from the source cassette. Wafer No. 1 removed from wafer slot No. 8 may take on the order of 1-3 minutes to complete its processing at the first processing chamber 140. Hence, the system will typically not be ready to receive wafer No. 2 for at least a minute while wafer No. 1 is being processed at the first station. As a result, the source cassette has a relatively long period of time (on the order of a minute or greater) to travel the relatively short distance between wafer slots (on the order of 1/4 inch) to position the next wafer slot, here wafer slot No. 7. Thus, the source cassette can move very slowly to position the next unprocessed wafer to be unloaded to reduce or eliminate the generation of contaminating particles yet still position the wafer in time for it to be unloaded without causing the robot to wait.

It is seen from the above and as illustrated in Fig. 9 that because the source cassette is used only to unload wafers, the source cassette need only move the distance separating each wafer slot each time a wafer is to be unloaded. This is true for all of the wafers of the source cassette. Comparing the movements of the source cassette of Fig. 9 to the cassette of Fig. 4, it is readily apparent that the source cassette of each unload and load cycle of the illustrated embodiment need only be indexed to move a short distance each time a wafer is to be unloaded in contrast to the cassette of Fig. 4 which is required to move a relatively large distance at what can be a relatively large rate after the robot starts to load processed wafers into the same cassette. As a consequence, the opportunity for the generation of contaminating particles is substantially reduced in the source cassette of the illustrated embodiment.

As previously mentioned, the processing system 100 of the embodiment of Fig. 6 has four processing chambers 140. Hence, by the time unprocessed wafer No. 5 is to be unloaded from the source destination, the first wafer (wafer No. 1) from slot No. 8 will have completed its sequence through the four chambers and will be ready to be loaded into the destination cassette of the cycle. In the illustrated embodiment, it is preferred that the processed wafers be loaded into the destination cassette starting at the top wafer slot and working down to the bottom wafer slot of the destination cassette.

Hence, as shown in Fig. 9, the first processed wafer to be loaded into the destination cassette in this cycle will be loaded into the top wafer slot, i.e., wafer slot No. 1. It is noted that the destination cassette of the cycle illustrated in Fig. 9 is the source cassette in the prior cycle. Since the last wafer unloaded from the cassette when it was the source cassette was unloaded from wafer slot No. 1 (unload bottom to top), the cassette now that it is the destination cassette is empty and already in position to load the first wafer into wafer slot No. 1 at the beginning of this cycle.

Once the robot loads the processed wafer into wafer slot No. 1, the destination cassette can be very slowly raised as shown in Fig. 9 to position the next wafer slot, i.e. wafer slot No.2, to be in alignment with the robot in anticipation of the next wafer to be loaded into the destination cassette. Wafer No. 2 may take on the order of 1-3 minutes to complete its processing at the last processing chamber 140. Hence, the system will typically not be ready to deliver wafer No. 2 for at least a minute. As a result, the destination cassette has a relatively long period of time (on the order of a minute or greater) to travel the relatively short distance between wafer slots (on the order of 1/4 inch) to position the next wafer slot, here wafer slot No. 2, in alignment with the robot to receive the processed wafer. Thus, the destination cassette like the source cassette, can move very slowly to position the next wafer slot to reduce or eliminate the generation of contaminating particles yet still position the wafer slot in time for the next wafer to be loaded.

This is true for all of the wafers of the destination cassette because the destination cassette is used only to load wafers therein during a particular load-unload cycle. (Of course, after the source cassette of that load-unload cycle has been unloaded, that cassette becomes the new destination cassette in the next load-unload cycle.) Comparing the movements of the destination cassette of Fig. 9 to the cassette of Fig. 4, it is readily apparent that the destination cassette, like the source cassette, of each load and load cycle of the illustrated embodiment, need only be indexed to move an incremental short distance each time a wafer is to be loaded. In contrast, the cassette of Fig. 4 is required to move a relatively large distance at what can be a relatively large speed after the robot starts to load processed wafers into the same cassette from which it is unloading wafers. As a consequence, the opportunity for the generation of contaminating particles is substantially reduced in both the source and destination cassettes of the illustrated embodiment.

Still further, throughput can potentially be increased over that achieved in a two load lock system. As shown in Fig. 9, as the source cassette is lowered from the unloading position at cassette slot No. 4 to be in position to unload the unprocessed wafer in slot No. 3, the destination cassette can be simultaneously raised from the loading position at slot No. 1 to be in position to load a processed wafer into slot No. 2. Thus, there is no need to wait for the source cassette to be moved to the next unload position before the destination cassette is moved to the next load position. This time saving can, depending upon the particular application, permit the throughput to be increased.

As another consequence of simultaneous movement, not only are the distances that the source and destination cassettes must be moved each time substantially reduced, but the time available to index the source and destination cassettes to their respective next positions can be effectively doubled. Consequently the speed at which the cassettes need be moved can be further decreased to further reduce the generation of contaminating particles.

In contrast, in the two load lock system of Figs. 3 and 4, it is necessary to wait until the cassette has been moved into the unload position and the wafer has been unloaded before the cassette can be moved to the next load position. This delay can further decrease throughput.

Referring now to Fig. 10, a robot in accordance with a preferred embodiment of the present invention is indicated generally at 114. The robot 114 includes a robot hand 150 which is coupled to a robot arm 152. The robot hand 150 includes a blade, pocket or other suitable surface which receives and supports a wafer 13 placed in or on the hand 150. Front and rear stops 154 and 156, respectively restrict sliding motion of the wafer on the robot hand 150.

One acceptable robot structure is shown and described in U.S. Patent No. 5,227,708, incorporated herein by reference. Additionally, a dual blade version of this robot, as described in U.S. Patent No. 5,447,409, incorporated herein by reference, may also be used.

A rotation and translation mechanism 158 selectively moves the arm 152 and the hand 150 in a plane parallel to the wafer slots 1-8 of the cassette 160. This movement is preferably achieved by pivoting and extending the robot arm 152 but may be achieved by a variety of well known robot actuator mechanisms including x-y orthogonal translators. In the illustrated embodiment, the cassette 160 moves up and down but it is anticipated that relative elevational movement between the wafer slots and the robot blade 150 may alternatively be achieved by elevating the robot blade.

In one feature of the robot hand 150 of the present invention, the robot hand 150 includes a structural support 162 which together with the front stop 154, have a combined thickness d' measured in a plane orthogonal to the wafer slots of the cassette, which is substantially greater than the wafer slot to wafer slot separation d as shown in Fig. 10. Because the wafers are preferably unloaded from the bottom wafer slot up and are preferably loaded into the top wafer slot down, there is no wafer below the wafer being unloaded or loaded. Thus, the need for the robot hand 150 to pass between two adjacent wafers in two adjacent wafer slots is eliminated. As a result, the robot hand 150 can be much thicker than the wafer to wafer spacing in the cassette. Consequently, the supporting structure 162 of the robot hands or blades can be made much stronger to resist warping and bending. Still further, a single robot hand design can be used regardless of the wafer spacing in the cassette.

The primary limitations on the thickness of the robot hand are now no longer the wafer to wafer spacing but the distance d" between the bottom wafer and the bottom of the cassette as well as the size of the passageways linking the various chambers. For example, a robot hand may have a thickness d'= 3/4 inch in order to resist warping and flexing even though the wafer to wafer spacing in the cassette is only 1/4 inch.

The minimum wafer to wafer spacing for a typical wafer slot defined by upper and lower wafer supports 26a and 26b in a cassette is illustrated in Fig. 11 and is designated $d_{min}$. As shown in Fig. 11, the minimum wafer to wafer spacing $d_{min}$ may be defined as follows:

$$d_{min} = T1 + T2 + T3 + T4 + T5 + T6 \qquad (1)$$

where T1 is the thickness of each of the wafer supports 26;
T2 is the minimum permitted clearance between the topmost surface 170 of the wafer 13a being unloaded or loaded, and the bottommost surface 172 of the wafer support 26a above the wafer 13a;
T3 is the robot upward position tolerance which defines the maximum permitted upward positional deviation of the topmost wafer surface 170 from its nominal vertical position as the wafer 13a is being inserted or retracted;
T4 is the thickness of the wafer 13a being loaded (or unloaded);
T5 is the robot downward position tolerance which defines the maximum permitted downward positional deviation of the bottommost wafer surface 174 from its nominal vertical position as the wafer 13a is being inserted or retracted; and
T6 is the minimum permitted clearance between the bottommost surface 174 of the wafer 13a being unloaded or load, and the topmost surface 176 of the wafer support 26b below the wafer 13a.

Because the thickness d' of the robot hand 150 is not limited by the wafer to wafer spacing d in the cassette, the robot hand can have a thickness d' which is substantially thicker than the minimum cassette wafer to wafer spacing $d_{min}$. it is recommended that the minimum wafer to wafer spacing $d_{min}$ include minimum clearances T2 and T3 between the upper and lower surfaces of the wafer being moved and the upper and lower wafer supports 26a and 26b, respectively, which define the wafer slot, in order to reduce the chances of the wafer 13a being moved from striking the wafer support surfaces 172 or 176.

The cassette wafer to wafer minimum spacing is also a function of the robot vertical position tolerances T3 and T4. A tolerance for the vertical position of the wafer being carried by the robot hand is usually necessary because of vibrations or other vertical deflections of the robot hand as it carries the wafer 13a to or from the cassette. The cassette wafer to wafer spacing minimum may also be expressed as a function of a single robot vertical position tolerance T7 as follows:

$$d_{min} = T1 + T2 + T7 + T6 \qquad (2)$$

where the robot vertical position tolerance T7 defines the vertical thickness of the space which the wafer 13a being inserted or retracted is permitted to pass through as it is being inserted or retracted.

As shown in Fig. 11 and as also may be deduced by a comparison of the equations (1) and (2) above, the robot vertical position tolerance T7 is a function of the wafer thickness T4 and the maximum permitted upward and downward wafer deflections T3 and T5, respectively as follows:

$$T7 = T3 + T4 + T5. \qquad (3)$$

The control functions described above for the system 100 including the robot control, chamber venting and pumping control, and cassette indexing are preferably provided by a workstation (not shown) programmed to control these system elements in accordance with the above.

Fig. 7 shows a wafer processing system 200 in accordance with an alternative embodiment. The system 200 includes a transfer robot 214 positioned in a transfer chamber 216. As described in U.S. Pat. No. 5,186,718, it has been found that throughput can be significantly improved while maintaining vacuum isolation by adding intermediate and buffer chambers at varying levels of pressure between high vacuum process chambers and relatively lower vacuum pressure load lock chambers. For example, the system 200 of Fig. 7 has, in addition to the robot transfer chamber 216, a robot buffer chamber 218 (having a robot 219) and a pair of intermediate processing or treatment chambers 220. In this system, load lock chambers A, B and C and pretreating and orienter chambers 222 are positioned around the robot buffer chamber 218 whereas high vacuum processing chambers 224 (having a vacuum pressure on the order of $10^{-9}$ Torr) are arrayed around the robot transfer chamber 214 which may be at a somewhat lower vacuum pressure of $10^{-8}$ Torr. Wafers being transferred from the robot buffer chamber 214 (having a vacuum pressure on the order of $10^{-6}$ Torr) to the robot transfer chamber 214 pass through the intermediate treatment chambers 220 at a pressure of $10^{-7}$ Torr, for example.

Thus, it is seen that in the embodiment of Fig. 7, the system has 8 processing chambers at varying degrees of vacuum pressure. It is recognized that the systems can have a greater or fewer number of processing chambers, depending upon the particular application. In addition, although the systems are illustrated as having three load lock chambers, it is anticipated that the systems may have additional load lock chambers.

Having thus described preferred and alternative embodiments of the present invention, it is understood that one of usual skill in the art will derive alternatives and variations which are within the scope of the invention.

**Claims**

1.  A method of processing semiconductor workpieces, comprising:

    unloading an unprocessed workpiece from a first cassette in a first chamber;
    loading a processed workpiece into a second cassette in a second chamber; and
    loading a third cassette of unprocessed workpieces into a third chamber.

2.  A method of processing semiconductor workpieces, comprising:

    unloading unprocessed workpieces from a first cassette in a first chamber;
    loading processed workpieces into a second cassette in a second chamber; and
    loading a third cassette of unprocessed workpieces into a third chamber.

3.  The method of claim 2 wherein the unloading and loading comprises a) alternately unloading a single unprocessed workpiece from the first cassette in the first chamber and loading a single processed workpiece into the second cassette in the second chamber, and b) repeating a) above.

4.  The method of claim 2 wherein the workpieces are stacked in a vertical stack in each cassette, said unloading comprising unloading the workpieces from the bottom of the stack to the top of the stack.

5.  The method of claim 2 wherein the workpieces are stacked in a vertical stack in each cassette, said loading comprising loading the workpieces from the top of the stack to the bottom of the stack.

6.  The method of claim 2 further comprising:

    loading processed workpieces into the first cassette of the first load lock chamber after the first cassette of the first load lock chamber has been completely unloaded;
    removing the cassette of processed workpieces from the second load lock chamber;
    loading a cassette of unprocessed workpieces into the second load lock chamber; and
    unloading unprocessed workpieces from the third cassette of the third load lock chamber.

7.  The method of claim 6 further comprising:

    removing the first cassette of processed workpieces from the first load lock chamber;
    loading a cassette of unprocessed workpieces into the first load lock chamber;
    subsequently unloading unprocessed workpieces from the cassette of the second load lock chamber; and
    subsequently loading into the third cassette of the third load lock chamber processed workpieces which were unloaded from the cassette of the first load lock chamber prior to processing.

8.  A method of processing semiconductor wafers, comprising:

    unloading an unprocessed wafer from a first wafer slot position in a first cassette in a first chamber;
    loading a processed wafer into a first wafer slot position in a second cassette in a second chamber;

indexing the first cassette to align the adjacent wafer slot position of the first cassette with a robot hand;

indexing the second cassette to align the adjacent wafer slot position of the second cassette with the robot hand wherein at least a portion of the indexings of the first and second cassettes are performed simultaneously; and

placing a third cassette of unprocessed wafers in a third chamber.

9. A system for processing semiconductor workpieces, comprising:

a robot chamber; and

first, second and third load lock chambers coupled to the robot chamber, each load lock chamber having a removable cassette for holding processed and unprocessed semiconductor workpieces.

10. The system of claim 9 wherein the robot chamber includes a robot for loading and unloading workpieces, wherein said robot in a first cycle: 1) unloads unprocessed workpieces from the cassette in the first load lock chamber; and 2) loads processed workpieces into the cassette of the second load lock chamber.

11. The system of claim 10 wherein the robot in a second cycle: 3) unloads unprocessed workpieces from the cassette in the third load lock chamber; and 4) loads processed workpieces into the cassette of the first load lock chamber.

12. The system of claim 11 wherein the robot in a third cycle: 5) unloads unprocessed workpieces from the cassette in the second load lock chamber; and 6) loads processed workpieces into the cassette of the third load lock chamber.

13. The system of claim 12 wherein the robot cyclicly and sequentially repeats the first, second and third cycles.

14. The system of claim 10 wherein each cassette has a plurality of slots arranged in a vertical stack, each slot being adapted to receive and support a workpiece to define a vertical stack of workpieces in each cassette, and the robot unloads the workpieces from the bottom of the stack to the top of the stack.

15. The system of claim 10 wherein each cassette has a plurality of slots arranged in a vertical stack, each slot being adapted to receive and support a workpiece to define a vertical stack of workpieces in each cassette, and the robot loads the workpieces from the top of the stack of slots to the bottom of the stack of slots to form a vertical stack of workpieces from the top down.

16. The system of claim 9 wherein each cassette has a plurality of slots arranged in a vertical stack, each slot being adapted to receive and support a workpiece to define a vertical stack of workpieces in each cassette,

wherein the robot chamber includes a robot for loading and unloading workpieces, and each load lock chamber has indexing means for indexing the associated cassette to position the associated cassette to selectively load or unload a workpiece,

wherein said robot in a first cycle: 1) unloads a first unprocessed workpiece from a first slot in a first cassette in the first load lock chamber; and 2) loads a first processed workpiece into a second slot in a second cassette in the second load lock chamber,

and wherein in said first cycle 1) said indexing means of the first load lock chamber indexes the first cassette after the first unprocessed workpiece has been unloaded from the first workpiece slot in the cassette to position the first cassette to unload the next adjacent unprocessed workpiece of the first cassette, and 2) the indexing means of second load lock chamber indexes the second cassette after the first processed workpiece has been loaded into the second workpiece slot in the second cassette to position the second cassette to load the next processed workpiece into the next adjacent slot of the second cassette, wherein at least a portion of the indexings of the first and second cassettes are performed simultaneously.

17. A system for processing semiconductor workpieces, comprising:

a transfer chamber;

at least three load lock chambers coupled to the transfer chamber, each load lock chamber having a removable cassette for holding processed and unprocessed workpieces wherein each cassette has a plurality of slots arranged in a vertical stack, each slot being adapted to receive and support a workpiece to define a vertical stack of workpieces in each cassette; and means for

1) in a first cycle a) unloading an unprocessed workpiece from a slot in the first cassette, b) indexing the first cassette downward to position the first cassette to unload the next adjacent unprocessed workpiece from the first cassette, c) loading a processed workpiece into a slot in the second cassette, d) indexing the second cassette upward to position the second cassette to load the next processed workpiece into the next adjacent slot of the second cassette, and e) repeating 1a-1d above;

2) in a second cycle a) unloading an unprocessed workpiece from a slot in the third cassette, b) indexing the third cassette downward to position the third cassette to unload the next adjacent unprocessed workpiece from the third cassette, c) loading a processed workpiece into a slot in the first cassette, d) indexing the first cassette upward to position the first cassette to load the next processed workpiece into the next adjacent slot of the first cassette, and e) repeating 2a-2d above; and

3) in a third cycle a) unloading an unprocessed workpiece from a slot in the second cassette, b) indexing the second cassette downward to position the second cassette to unload the next adjacent unprocessed workpiece from the second cassette, c) loading a processed workpiece into a slot in the third cassette, d) indexing the third cassette upward to position the third cassette to load the next processed workpiece into the next adjacent slot of the third cassette, and e) repeating 3a-3d above.

18. A method of processing semiconductor workpieces in combination with a plurality of cassettes, wherein each cassette has a plurality of slots arranged in a vertical stack, each slot being adapted to receive and support a workpiece to define a vertical stack of workpieces in each cassette, the method comprising:

1) in a first cycle a) unloading an unprocessed workpiece from a first cassette having a plurality of unprocessed workpieces, b) indexing the first cassette downward to position the first cassette to unload the next adjacent unprocessed workpiece from the first cassette, c) loading a processed workpiece into a second cassette having a plurality of empty slots, d) indexing the second cassette upward to position the second cassette to load the next processed workpiece into the next adjacent slot of the second cassette, and e) repeating 1a-1d above;

2) in a second cycle a) unloading an unprocessed workpiece from a third cassette having a plurality of unprocessed workpieces, b) indexing the third cassette downward to position the third cassette to unload the next adjacent unprocessed workpiece from the third cassette, c) loading a processed workpiece into the first cassette, d) indexing the first cassette upward to position the first cassette to load the next processed workpiece into the next adjacent slot of the first cassette, and e) repeating 2a-2d above; and

3) in a third cycle a) unloading an unprocessed workpiece from the second cassette having a plurality of unprocessed workpieces, b) indexing the second cassette downward to position the second cassette to unload the next adjacent unprocessed workpiece from the second cassette, c) loading a processed workpiece into the third cassette, d) indexing the third cassette upward to position the third cassette to load the next processed workpiece into the next adjacent slot of the third cassette, and e) repeating 3a-3d above.

19. A robot for loading and unloading workpieces from a cassette in a semiconductor processing system in which the workpieces in the cassette are stacked in a vertical stack having a predetermined distance d between the workpieces of the stack, comprising:

a robot hand having a surface for receiving and supporting a workpiece; and
a robot arm coupled to the robot hand for moving the robot hand and the workpiece received within the robot hand,
said robot hand including a support structure coupled to the robot arm and positioned to underlie the workpiece and support the robot hand surface, said support structure having a vertically measured thickness in excess of the predetermined distance d.

20. The robot of claim 19 wherein the cassette has a plurality of workpiece supports which are spaced to support the workpieces of the vertical stack at the predetermined distance d and wherein the predetermined distance d is a function of a predetermined minimum spacing between the workpiece on the robot hand and the workpiece supports of the cassette as the workpiece on the robot hand is inserted into or removed from the cassette.

21. The robot of claim 20 wherein the predetermined distance d is also a function of a predetermined maximum vertical movement of the robot hand as the workpiece on the robot hand is inserted into or removed from the cassette.

22. The robot of claim 20 wherein the cassette has a plurality of workpiece supports which are vertically spaced to support the workpieces of the vertical stack at the predetermined distance d, wherein an upper workpiece support and a lower workpiece support define a slot, wherein the robot arm moves the robot hand and hence the workpiece on the robot hand into and out of the slot at a predetermined nominal vertical position of the workpiece between the upper and lower workpiece supports, and wherein the predetermined distance d is defined as follows:

$$d = T1 + T2 + T3 + T4 + T5 + T6 \qquad (1)$$

where T1 is the thickness of the upper workpiece support;

T2 is a predetermined minimum permitted clearance between the workpiece on the robot hand and the upper workpiece support above the workpiece on the robot hand;

T3 is a predetermined maximum permitted upward positional deviation of the workpiece on the robot hand from its nominal vertical position as the workpiece is moved into and out of the slot;

T4 is the thickness of the workpiece on the robot hand;

T5 is a predetermined maximum permitted downward positional deviation of the workpiece from its nominal vertical position as the workpiece is moved into and out of the slot; and

T6 is a predetermined minimum permitted clearance between the workpiece on the robot hand and the lower workpiece support below the workpiece on the robot hand.

Fig. 1

Fig. 2

*Fig. 3*

EP 0 800 203 A2

Fig. 4

*Fig. 5*

*Fig. 10*

Fig. 7

Fig. 6

| CYCLE | LOAD LOCK A | LOAD LOCK B | LOAD LOCK C |
|---|---|---|---|
| Initial conditions at start of cycle 1 | Full unprocessed wafer cassette | Empty cassette | Full unprocessed wafer cassette |
| Cycle 1 | Unload unprocessed wafers from cassette | Load processed wafers into cassette | — |
| Cycle 2 | Load processed wafers into cassette | Remove full processed wafer cassette and replace with full unprocessed wafer cassette | Unload unprocessed wafers from cassette |
| Cycle 3 | Remove full processed wafer cassette and replace with full unprocessed wafer cassette | Unload unprocessed wafers from cassette | Load processed wafers into cassette |
| Cycle 4 | Unload unprocessed wafers from cassette | Load processed wafers into cassette | Remove full processed wafer cassette and replace with full unprocessed wafer cassette |
| Cycle 5 | Load processed wafers into cassette | Remove full processed wafer cassette and replace with full unprocessed wafer cassette | Unload unprocessed wafers from cassette |
| Cycle 6 | Remove full processed wafer cassette and replace with full unprocessed wafer cassette | Unload unprocessed wafers from cassette | Load processed wafers into cassette |
| Cycle 7 | Unload unprocessed wafers from cassette | Load processed wafers into cassette | Remove full processed wafer cassette and replace with full unprocessed wafer cassette |

*Fig. 8*

EP 0 800 203 A2

Fig. 9

*Fig. 11*